# EUROPEAN PATENT APPLICATION

(11) **EP 4 760 768 A1**
(43) Date of publication of application: **17.06.2026**
(21) Application number: 24782160.6
(22) Date of filing: 31.07.2024
(51) Int. Cl.: H01H 83/00, G01R 31/52, H02H 3/32, H02H 3/10, H02H 3/02

(54) **ELECTRICAL LEAKAGE PROTECTION APPARATUS AND ELECTRICAL DEVICE**

(30) Priority: 07.08.2023 CN 202310985107
(71) Applicant: SENSATA TECHNOLOGIES CHANGZHOU CO., LTD., Xinbei District Changzhou Jiangsu 213031 (CN)
(72) Inventor: FU, Jianjun, Yangzhou Jiangsu 225800 (CN); LIU, Biao, Shengzhixiaxianjixingzhengquhua Hubei 433000 (CN); WANG, Wenguang, Changzhou Jiangsu 213000 (CN)
(74) Representative: Torggler & Hofmann Patentanwälte - Innsbruck
(86) International application number: PCT/CN2024/108772
(87) International publication number: WO 2025/031226

(57) **Abstract**

The present application relates to a leakage protection device, wherein the leakage protection device comprises a leakage detection module and a circuit breaker module, characterized in that the circuit breaker module comprises a first coil mechanism for short circuit protection and a second coil mechanism for leakage protection, wherein the leakage detection module is connected to the second coil mechanism via a first electrical transmission line. In addition, the present application relates to an electrical device, comprising a first power supply line from a power source, a second power supply line leading to a load and the leakage protection device according to present application.

## Description

### Technical Field

The present application generally relates to the field of leakage protection, and more specifically, to a leakage protection device and an electrical device, wherein the electrical device includes the leakage protection device.

### Background of Invention

When the insulation of electrical circuits or electrical device is damaged, contact with these damaged insulation areas may result in a ground short, i.e. leakage may occur and poses a threat to personal safety. The causes of leakage or ground short may also stem from energy releases in electrical circuits or electrical device due to high temperatures, arcs, etc. If not addressed promptly, this can lead to electrical fires.

A leakage protection device is an important protective device that prevents electric shock to individuals or electrical fires when leakage or ground short occur in electrical circuits or electrical device. It may also be referred to as a Ground Fault Circuit Interrupter (GFCI). When leakage or a ground short occurs, abnormal current or voltage signals will be present in the circuit. The leakage protection device detects and processes these abnormal current or voltage signals, prompting the actuator to react to eliminate potential dangers. In general, the leakage protection device realizes protection function by detecting leakage current in the circuit and prompting the circuit breaker to trip, thereby shutting down the circuit.

CN104851759A discloses a leakage protection device that includes a sensing module and a circuit breaker module. The sensing module comprises a leakage trip coil, a delay core, and a tripping mechanism, wherein the tripping rod of the tripping mechanism needs to extend from the sensing module into the interior of the circuit breaker module to trip the breaker. However, this leakage protection device has a large number of components, resulting in higher costs. Furthermore, the tripping mechanical transmission mechanism between different modules, such as multiple linkages, makes the internal structure of the device relatively complex. Therefore, it is desirable to provide a leakage protection device that is structurally simplified and/or cost-effective. Additionally, it is also desirable to improve or expand the functionality of the leakage protection device.

### Summary of Invention

It is an object of the present application to provide a leakage protection device and an electrical device capable of overcoming at least one of the drawbacks in the prior art.

According to a first aspect of the present application, there is a leakage protection device provided, wherein the leakage protection device comprises a leakage detection module and a circuit breaker module, characterized in that the circuit breaker module comprises a first coil mechanism for short circuit protection and a second coil mechanism for leakage protection, wherein the leakage detection module is connected to the second coil mechanism via a first electrical transmission line.

In some embodiments, the leakage protection device includes an intermediate housing arranged between the circuit breaker module and the leakage detection module, wherein the leakage detection module and the circuit breaker module are separated from each other by the intermediate housing.

In some embodiments, the intermediate housing is provided with a through hole, wherein the first electrical transmission line extends from the leakage detection module through the through hole into the circuit breaker module.

In some embodiments, no tripping mechanical transmission mechanism is present between the circuit breaker module and the leakage detection module.

In some embodiments, no coil mechanism for leakage protection is provided within the leakage detection module.

In some embodiments, the first coil mechanism and the second coil mechanism are arranged coaxially.

In some embodiments, the first coil mechanism and the second coil mechanism are coaxially disposed on a core.

In some embodiments, the first coil mechanism comprises a first coil sleeve and a first coil wound around the first coil sleeve, the second coil mechanism comprises a second coil sleeve and a second coil wound around the second coil sleeve, wherein the first coil sleeve and the second coil sleeve are coaxially disposed on a core.

In some embodiments, the first coil sleeve and the second coil sleeve are configured as an I-shaped sleeve.

In some embodiments, the first coil sleeve and the second coil sleeve are in contact with each other.

In some embodiments, the first coil mechanism and the second coil mechanism comprise a coil sleeve and a first coil and a second coil wound around the coil sleeve.

In some embodiments, the first coil mechanism comprises a first coil wound around a core, and the second coil mechanism comprises a second coil wound around the core.

In some embodiments, the first coil mechanism comprises a first coil wound around a core, and the second coil mechanism comprises a coil sleeve and a second coil wound around the coil sleeve.

In some embodiments, the leakage detection module comprises a leakage detector and a circuit board, wherein the circuit board is connected to the second coil mechanism via a first electrical transmission line, and the leakage detector is connected to the circuit board via a second electrical transmission line.

In some embodiments, the leakage detection module further includes a simulated leakage operation part, which is configured to establish a leakage loop when the simulated leakage operation part is operated, thus simulating the occurrence of a leakage fault, wherein the leakage loop extends through the leakage detector, the simulated leakage operation part, and the circuit board.

In some embodiments, the leakage detection module further includes a communication module, which is configured to receive remote control signals, and the circuit board controls the second coil mechanism via the first electrical transmission line in response to the control signals.

In some embodiments, the circuit breaker module further comprises: an armature; a transmission mechanism; and a contact assembly, which includes a movable contact and a stationary contact, wherein the armature, the transmission mechanism, and the contact assembly are mechanically connected to each other.

In some embodiments, the first coil mechanism is configured to trigger the movement of the armature in the event of a short circuit fault occurring in the main circuit, thereby driving the movement of the contact assembly via the transmission mechanism for the purpose of disconnecting the main circuit.

In some embodiments, the second coil mechanism is configured to trigger the movement of the armature in the event of a leakage fault occurring, thereby driving the movement of the contact assembly via the transmission mechanism for the purpose of disconnecting the main circuit.

In some embodiments, the transmission mechanism comprises: a lock latch; a jump latch; and a movable contact bracket, wherein the lock latch and the jump latch are releasably connected to each other, the jump latch and the movable contact bracket are rotatably connected to each other, and the movable contact bracket and the movable contact are rotatably connected to each other.

In some embodiments, in a normal operating mode, the lock latch and the jump latch match and lock with each other, and the jump latch and the movable contact bracket match and lock with each other, such that the transmission mechanism forms a four-bar linkage, thereby making the movable contact engage with the stationary contact.

In some embodiments, in the event of a short circuit fault or a leakage fault, the armature drives the lock latch and the jump latch to unlock, such that the transmission mechanism transforms into a five-bar linkage, thereby enabling the movable contact bracket to drive the movable contact to disconnect from the stationary contact.

In some embodiments, the circuit breaker module further includes a handle, which is rotatably connected to the jump latch.

In some embodiments, the circuit breaker module further includes an overload detection device, which is configured to detect overload faults in the main circuit, and directly causes the movement of the lock latch to unlock the lock latch from the jump latch upon detecting an overload fault.

In some embodiments, the overload detection device is configured as a bimetallic strip means and deforms due to heating when an overload fault occurs in the main circuit, thereby pushing the lock latch.

In some embodiments, the circuit breaker module comprises an emergency switch and an emergency switch transmission line, wherein the emergency switch is electrically connected to the second coil mechanism via the emergency switch transmission line.

In some embodiments, the circuit breaker module includes a remote control transmission line, which is electrically connected to the second coil mechanism.

According to a second aspect of the present application, there is an electrical device, such as a charging device or a charging station provided, characterized in that the electrical device comprises a first power supply line from a power source, a second power supply line leading to a load, and the leakage protection device according to some embodiments of present application, wherein the first power supply line is connected to the input terminal of the leakage protection device and the second power supply line is connected to the output terminal of the leakage protection device.

### Brief Description of Drawings

The following detailed description of the present application will be accompanied by specific embodiments with reference to the accompanying drawings. The accompanying figures are briefly described as follows:
Figure 1 is a perspective view of a leakage protection device according to some embodiments of the present application;
Figure 2 is an exemplary internal layout view of the circuit breaker module of a leakage protection device according to some embodiments of the present application;
Figure 3 is an exemplary internal layout view of the leakage detection module of a leakage protection device according to some embodiments of the present application;
Figure 4 is an internal layout view of a leakage protection device according to some embodiments of the present application, omitting the housing structure;
Figure 5 is a front view of the internal layout depicted in Figure 4;
Figure 6 is a schematic state view of the circuit breaker module in a normal operating mode;
Figure 7 is a schematic state view of the circuit breaker module in an abnormal operating mode.

### Detailed Description

The present application will be described below with reference to the accompanying figures, which show several embodiments of the present application. However, it should be understood that the present application can be presented in many different ways and is not limited to the embodiments described below. In fact, the embodiments described below are intended to make the present application more complete and to fully explain the protection scope of the present application to those skilled in the art. It should also be understood that the embodiments disclosed in the present application may be combined in various ways so as to provide more additional embodiments.

It should be understood that the words in the specification are only used to describe specific embodiments and are not intended to limit the present application. Unless otherwise defined, all terms (including technical terms and scientific terms) used in the Specification have the meanings commonly understood by those of ordinary skill in the art. For brevity and/or clarity, well-known functions or structures may not be further described in detail.

In the Specification, words expressing spatial relations such as "upper", "lower", "left", "right", "front", "rear", "top", and "bottom" may describe the relation between one feature and another feature in the attached drawings. It should be understood that, in addition to the locations shown in the attached drawings, the words expressing spatial relations further include different locations of a device in use or operation. For example, when a device in the attached drawings rotates reversely, the features originally described as being "below" other features now can be described as being "above" the other features. The device may also be oriented by other means (rotated by 90 degrees or at other locations), and next, a relative spatial relation will be explained accordingly.

In this document, the term "A or B" includes both "A and B" and "A or B," and does not exclusively refer to only "A" or only "B," unless otherwise specified.

The terms "illustrative" or "exemplary" in this document refer to "used as an example, instance, or illustration," rather than as a "model" to be precisely replicated. Any implementation described as exemplary should not be interpreted as preferred or advantageous over other implementation methods. Furthermore, this application is not limited by any theories expressed or implied in the aforementioned technical field, background technology, content of the invention, or specific embodiments.

The term "substantially" in this document means including any minor variations due to tolerances in design or manufacturing defects, environmental influences, and/or other factors.

The term "partially" in this document can refer to any proportion of a part. For instance, it could be greater than 10%, 20%, 30%, 40%, 50%, 60%, 70%, 80%, 90%, or even as much as 100%, meaning all.

Additionally, solely for reference purposes, terms such as "first," "second," and similar terminology may be used in this document, and are not intended to be limiting. For example, unless the context clearly indicates otherwise, the terms "first," "second," and other such numerical terms relating to structures or components do not imply any order or sequence.

Now, some embodiments of the present application will be described in greater detail with reference to the accompanying figures.

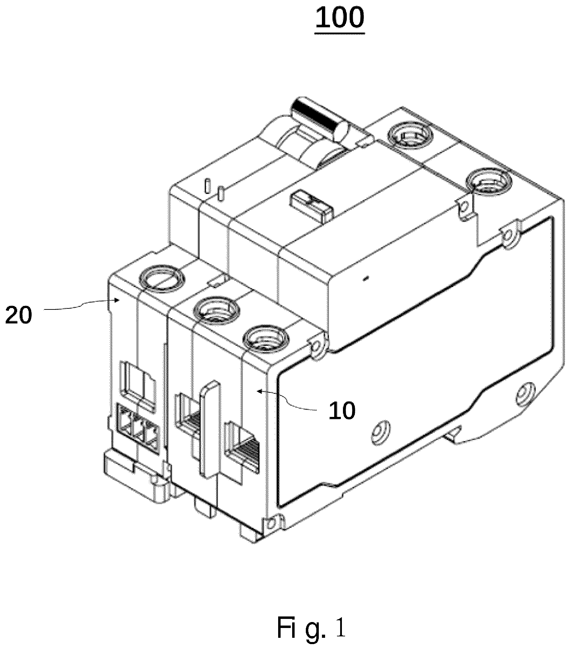

Referring to Figure 1, a perspective view of the leakage protection device 100, according to some embodiments of the present application, is shown. As illustrated in Figure 1, the leakage protection device 100 may comprise a leakage detection module 10 and a circuit breaker module 20. The leakage detection module 10 may be configured to detect or identify leakage fault events or ground short fault events. The circuit breaker module 20 may be configured to perform a disconnection operation for the main circuit, i.e., tripping, when the leakage detection module 10 detects a leakage fault.

According to some embodiments of the present application, the leakage protection device 100 may be applied to an electrical device, such as charging device or a charging station. The electrical device can include a first power supply line from a power source, a second power supply line leading to a load, and the leakage protection device as described in some embodiments of the present application. The first power supply line connects to the input terminal of the leakage protection device, while the second power supply line connects to the output terminal of the leakage protection device.

Additionally or alternatively, the circuit breaker module 20 may be configured to detect or identify short circuit faults in the main circuit (for example, short circuit occurring between the neutral wire and the live wire), and to perform a disconnection operation for the main circuit, i.e., tripping, upon detecting such short circuit faults.

Additionally or alternatively, the circuit breaker module 20 may be configured to detect or identify overload faults in the main circuit, and to perform a disconnection operation for the main circuit, i.e., tripping, upon detecting such overload faults.

Advantageously, the leakage protection device 100 may be assembled in a modular fashion. That is to say, the leakage detection module 10 of the leakage protection device 100 can be constructed as a relatively independent module and can be manufactured independently of the circuit breaker module 20. The leakage detection module 10 may have its own housing and an independent accommodation space within the housing. Similarly, the circuit breaker module 20 of the leakage protection device 100 can also be constructed as a relatively independent module and manufactured independently of the leakage detection module 10. The circuit breaker module 20 may have its own housing and an independent accommodation space within the housing. This modular assembly approach is advantageous, as it allows for the efficient combination of different types of the leakage detection module 10 and the circuit breaker module 20 to achieve various types of the leakage protection device 100.

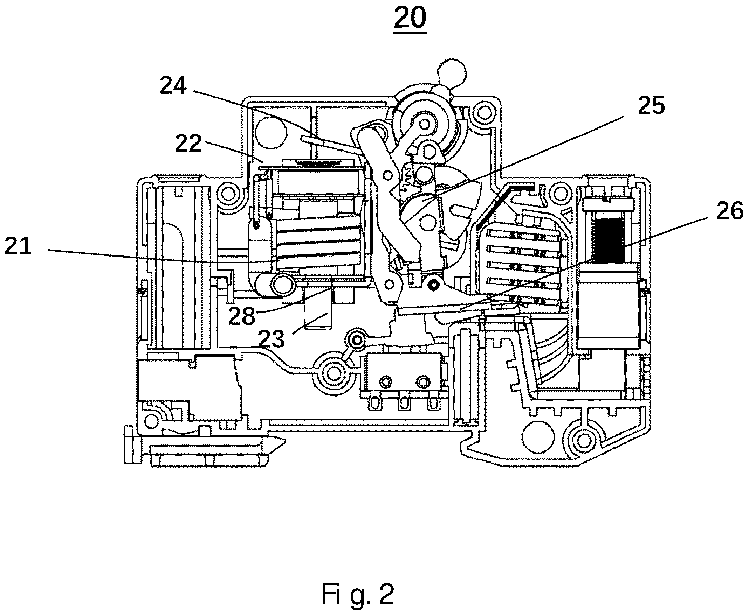

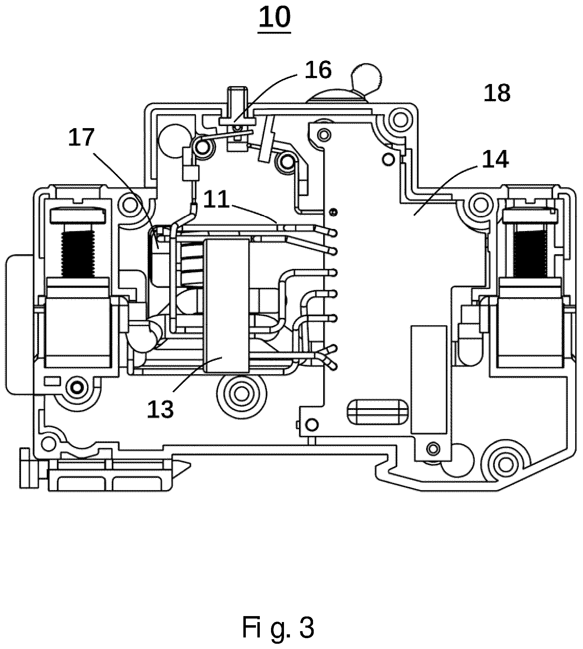

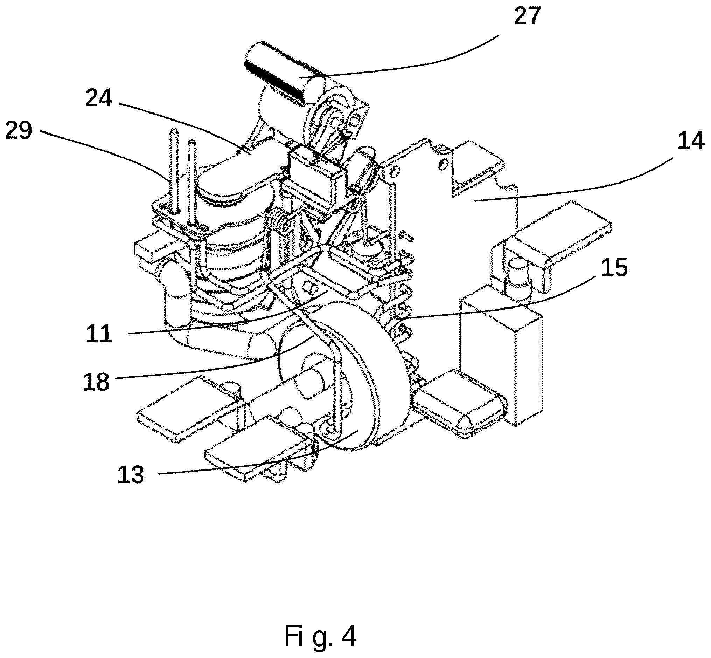

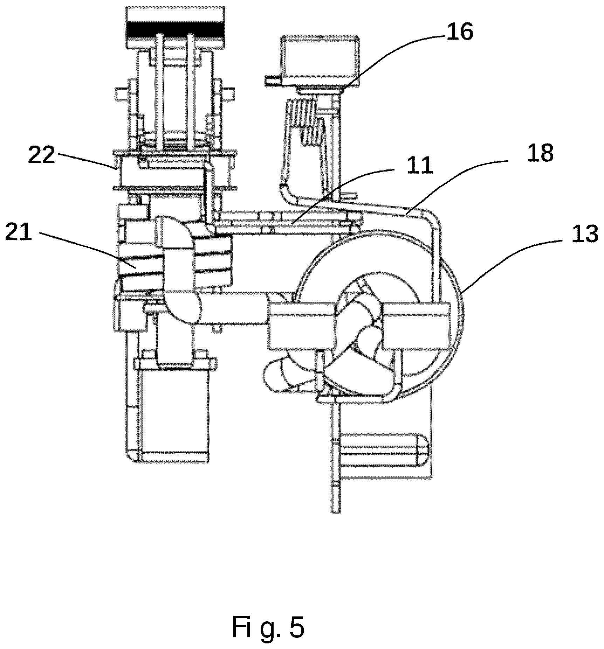

Next, with reference to Figures 2-5, the leakage protection device 100 according to some embodiments of the present application will be described in detail. Figure 2 shows an exemplary internal layout view of the circuit breaker module 20 of a leakage protection device 100 according to some embodiments of the present application. Figure 3 shows an exemplary internal layout view of the leakage detection module 10 of a leakage protection device 100 according to some embodiments of the present application. Figure 4 shows an internal layout view of a leakage protection device 100 according to some embodiments of the present application, omitting the housing structure. Figure 5 shows a front view of the internal layout depicted in Figure 4.

As shown in Figures 2, 4, and 5, the circuit breaker module 20 may include a housing and various functional components arranged within or on the housing. The circuit breaker module 20 may include a first coil mechanism 21 and a second coil mechanism 22 that is arranged separately from the first coil mechanism 21. The first coil mechanism 21 may be configured as a short-circuit protection coil mechanism and may also be referred to as the "main coil mechanism," while the second coil mechanism 22 may be configured as a leakage protection coil mechanism and may also be referred to as the "auxiliary coil mechanism." In other words, the circuit breaker module 20 of the present application can integrate not only the coil mechanism for short-circuit protection but also the coil mechanism for leakage protection. The integration of these tripping coil mechanisms for multiple protection mechanisms within the circuit breaker module 20 can significantly simplify the structural design of the leakage protection device 100 and effectively reduce manufacturing costs.

The circuit breaker module 20 may include an armature 24 that interacts with the first coil mechanism 21 and the second coil mechanism 22, a transmission mechanism 25 that cooperates with the armature 24, and a contact assembly 26 that cooperates with the transmission mechanism 25. The disconnection or engagement between the movable contact 261 and the stationary contact 262 of the contact assembly 26 can control the opening and closing of the main circuit. Advantageously, the first coil mechanism 21 and the second coil mechanism 22 can cooperate with a common armature 24 and thus with the common transmission mechanism 25 and the contact assembly 26. This structural design, where the first coil mechanism 21 and the second coil mechanism 22 share components, can significantly simplify the internal arrangement of the circuit breaker module 20 and effectively reduce manufacturing costs.

Specifically, under the action of the first coil mechanism 21, for example, when a first voltage or first current is applied to the first coil of the first coil mechanism 21, the first coil mechanism 21 can cause the armature 24 to move based on electromagnetic effects, thereby driving the transmission mechanism 25 and the contact assembly 26 to react, resulting in the disconnection or engagement between the movable contact 261 and the stationary contact 262 of the contact assembly 26. Under the action of the second coil mechanism 22, for example, when a second voltage or second current is applied to the second coil of the second coil mechanism 22, the second coil mechanism 22 can cause the armature 24 to move based on electromagnetic effects, thereby driving the transmission mechanism 25 and the contact assembly 26 to react, resulting in the disconnection or engagement between the movable contact 261 and the stationary contact 262 of the contact assembly 26.

In some embodiments, the first coil mechanism 21 may be arranged coaxially with the second coil mechanism 22. For instance, the first coil mechanism 21 and the second coil mechanism 22 can be coaxially disposed onto a core 23. The armature 24 that interacts with the coil mechanisms can be positioned on the upper or lower side of the core 23. As illustrated in Figure 2, the first coil mechanism 21 may include a first coil sleeve and a first coil wound around the first coil sleeve. The second coil mechanism 22 may include a second coil sleeve and a second coil wound around the second coil sleeve. The first coil sleeve and the second coil sleeve can be positioned coaxially on the core 23. This configuration achieves a compact arrangement of the coil assembly for short-circuit protection and leakage protection. Furthermore, it is advantageous that the first coil sleeve and the second coil sleeve are configured in an I-shaped design, and they can be arranged with a spacing distance on the core 23 or positioned closely against each other on the core 23.

In other embodiments, it is also possible for the first coil mechanism 21 to comprise a first coil wound around the core 23, while the second coil mechanism 22 may include a second coil also wound around the core 23.

In additional embodiments, it is also possible for the first coil mechanism 21 to include a first coil wound around the core, and the second coil mechanism 22 to comprise a coil sleeve and a second coil wound around that coil sleeve. This allows for convenient subsequent installation of the second coil mechanism.

In other embodiments, it is also possible for the first coil mechanism 21 and the second coil mechanism 22 to interact with their respective armatures 24. The corresponding coil mechanisms can induce the movement of the respective armature 24 based on the electromagnetic effect, thereby driving the transmission mechanism 25 and the contact assembly 26 to react, resulting in the disconnection or engagement between the movable contact 261 and the stationary contact 262 of the contact assembly 26.

In other embodiments, the first coil mechanism 21 and the second coil mechanism 22 may include one coil sleeve, with the first coil and the second coil wound around that coil sleeve. This further improves the compact arrangement of the coil assembly for short-circuit protection and leakage protection.

In some embodiments, the circuit breaker module 20 may further include an overload detection device 28, which can be configured to detect overload faults in the main circuit. When the overload detection device 28 detects an overload fault, it can directly actuate the transmission mechanism 25 and the contact assembly 26 or indirectly actuate the transmission mechanism 25 and the contact assembly 26 via a corresponding mechanical mechanism, thereby disconnecting the main circuit.

In some embodiments, the overload detection device 28 may be configured as a bimetallic strip means. The bimetallic strip means may deform due to heating when an overload fault occurs in the main circuit, for example, when the current exceeds a predetermined value, thus driving the transmission mechanism 25 and the contact assembly 26 to react, resulting in the disconnection of the main circuit.

It should be understood that both short-circuit faults and overload faults may exhibit a significant increase in the current within the main circuit, for example, several times above the rated current. However, the leakage protection device 100 of this application distinguishes between short-circuit faults and overload faults and takes corresponding different measures. For short-circuit faults, the leakage protection device 100 utilizes the electromagnetic response mechanism of the first coil mechanism 21 in conjunction with the armature 24 to achieve a rapid response, as short-circuit faults are typically extremely dangerous and require immediate action. In contrast, for overload faults, the leakage protection device 100 employs the response mechanism of the overload detection device 28 based on thermal deformation to achieve a relatively slower response. This is because overload faults are generally caused by excessive load and can typically allow for a certain redundancy in response time; otherwise, it may lead to negative impacts from repeated disconnections. To achieve this distinction, a current threshold can be established, such that when the current in the main circuit is greater than or equal to this current threshold, it is determined to be a short-circuit fault, while when the current is less than this current threshold, it is determined to be an overload fault. To this end, the first coil mechanism 21 and the armature 24 can be configured such that the actuation operation to the armature 24 (for example, attracting or pushing away the armature) is only triggered when a current greater than or equal to the current threshold is applied to the first coil of the first coil mechanism 21; otherwise, the armature 24 will not be actuated by the first coil mechanism 21.

In some embodiments, the first coil of the first coil mechanism 21 can be connected in series with the main circuit, thereby allowing the current on the main circuit to flow through directly to achieve a rapid and accurate response. The ends of the first coil can be electrically connected to the movable contact 261 and the external terminal via a soldered metal wire segment, such as copper wire, respectively.

In some embodiments, the circuit breaker module 20 may also include a handle 27, which can be mechanically connected directly to the transmission mechanism 25 within the circuit breaker module 20 in order to manually trigger the contact assembly 26 into action. This enables the disconnection or engagement of the movable contact 261 and the stationary contact 262 of the contact assembly 26.

Additionally, or alternatively, the circuit breaker module 20 may include an emergency switch (not shown) and an emergency switch transmission line 29, wherein the emergency switch can be electrically connected to the second coil of the second coil mechanism 22 via the emergency switch transmission line 29. Upon operation, such as pressing the emergency switch, the emergency circuit can be closed, and a predetermined voltage or current can be applied to the second coil of the second coil mechanism 22, thereby triggering the disconnection of the main circuit.

Additionally, or alternatively, the circuit breaker module 20 may include a remote control transmission line (not shown), which can connect a remote control center, such as a control computer with the second coil mechanism 22. When it is necessary to remotely trigger the disconnection of the main circuit, the remote control center can apply a predetermined voltage or current to the second coil via the remote control transmission line to facilitate the disconnection of the main circuit.

As shown in Figures 3, 4, and 5, the leakage detection module 10 may include a housing and various functional devices arranged inside or on the housing. The leakage detection module 10 may comprise a leakage detector 13, which can be configured in any form of leakage detection device for detecting leakage faults. When the main circuit is a direct current (DC) circuit, the leakage detector 13 may be configured as a DC leakage detection device. When the main circuit is an alternating current (AC) circuit, the leakage detector 13 may be configured as an AC leakage detection device. In some embodiments, the leakage detector 13 may be configured as a current transformer, such as a zero-sequence current transformer. The live wire and neutral wire can simultaneously pass through the core of the current transformer 23. When leakage occurs on the live wire and/or neutral wire, the current transformer can detect the leakage current, thereby identifying the leakage fault.

Unlike the mechanical tripping mechanism that is traditionally found between the different modules of leakage protection devices 100, the leakage protection device 100 of the present application establishes an electrical connection between the leakage detection module 10 and the circuit breaker module 20, preferably only through this electrical connection. In other words, the leakage protection device 100 of the present application no longer includes a traditional mechanical tripping mechanism between the leakage detection module 10 and the circuit breaker module 20 but instead establishes a connection through the electrical transmission line 11, preferably only through the electrical transmission line 11. This can significantly simplify the structural design of the leakage protection device 100 and effectively reduce manufacturing costs.

The leakage detection module 10 may include a circuit board 14, such as a printed circuit board. The circuit board 14 can be connected via a first electrical transmission line 11 to a second coil mechanism 22 installed within the circuit breaker module 20 for leakage protection, and the circuit board 14 can be connected via a second electrical transmission line 15 to the leakage detector 13. When the leakage detector 13 detects a leakage fault, it can transmit a first electrical signal characterizing the occurrence of the leakage fault to the circuit board 14 via the second electrical transmission line 15. The circuit board 14 can then apply a second electrical signal, such as a predetermined voltage or current, to the second coil mechanism 22 via the first electrical transmission line 11, based on the receipt of the first electrical signal. Consequently, the second coil mechanism 22 can cause the armature 24 to move based on the applied voltage or current, thereby driving the transmission mechanism 25 and the contact assembly 26 to act, in order to disconnect the main circuit. Advantageously, it is no longer necessary to install a coil mechanism within the leakage detection module 10 for leakage protection, nor is it necessary to install the corresponding armature 24 and mechanical tripping mechanism within the leakage detection module 10. This significantly simplifies the structural design of the leakage protection device 100 and effectively reduces manufacturing costs.

According to a modular design concept, the circuit breaker module 20 and the leakage detection module 10 can be separated by an intermediate housing. To allow for electrical connection between the leakage detection module 10 and the circuit breaker module 20, the intermediate housing may be provided with a through hole 17, and the first electrical transmission line 11 can extend from the leakage detection module 10 (for example, its printed circuit board 14) through the through hole 17 into the circuit breaker module 20, specifically to the second coil mechanism 22. This arrangement ensures both physical isolation between the two modules (reducing unwanted interference between them) and allows for electrical connectivity between the two modules. In the illustrated embodiment, the circuit board 14 may be arranged close to the intermediate housing within the leakage detection module 10. Advantageously, the circuit board 14 may be positioned adjacent to the through hole 17 in the intermediate housing, thereby allowing the first electrical transmission line 11 to pass through the through hole 17 from one side of the circuit board 14 into the circuit breaker module 20 with a shorter extending path.

In some embodiments, the leakage detection module 10 may also include a simulated leakage operation part 16, which can be configured to establish a leakage loop 18 when the simulated leakage operation part 16 is operated. This effectively simulates the occurrence of a leakage fault. Specifically, when the simulated leakage operation part 16 is activated, such as being pressed, a man-made leakage loop 18 is established. Advantageously, the leakage loop 18 can pass through the leakage detector 13, the simulated leakage operation part 16, and the circuit board 14. If the leakage detector 13 can detect this man-made leakage fault and subsequently trigger the tripping-response of the circuit breaker module 20 via the first electrical transmission line 11, it indicates that the leakage protection device 100 has an intact leakage protection function. Thus, the simulated leakage operation part 16 can beneficially simplify the maintenance of the leakage protection device 100.

Additionally or alternatively, the leakage detection module 10 may also include a communication module, which is configured to receive remote control signals, such as control signals from a remote control center. The circuit board 14 can respond to these control signals by manipulating the second coil mechanism 22 via the first electrical transmission line 11. For example, the circuit board 14 can apply a predetermined voltage or current to the second coil of the second coil mechanism 22 in response to the control signals received through the first electrical transmission line 11, thereby disconnecting the main circuit.

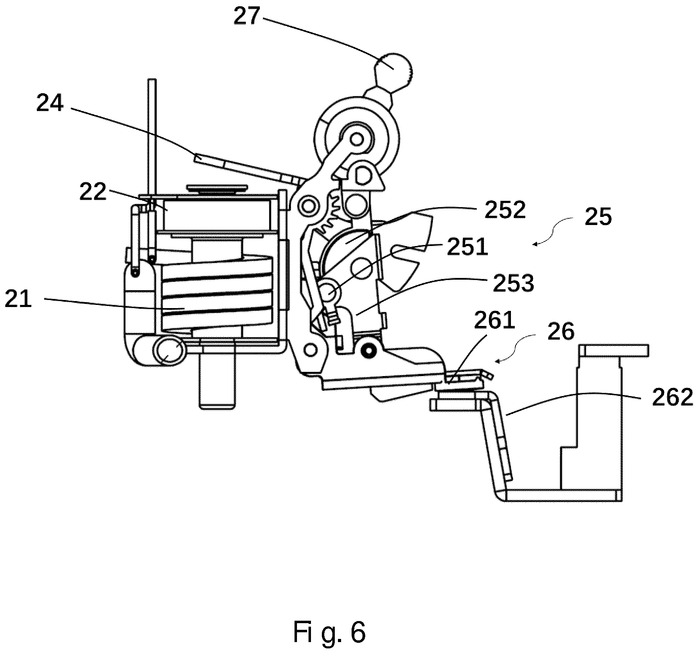

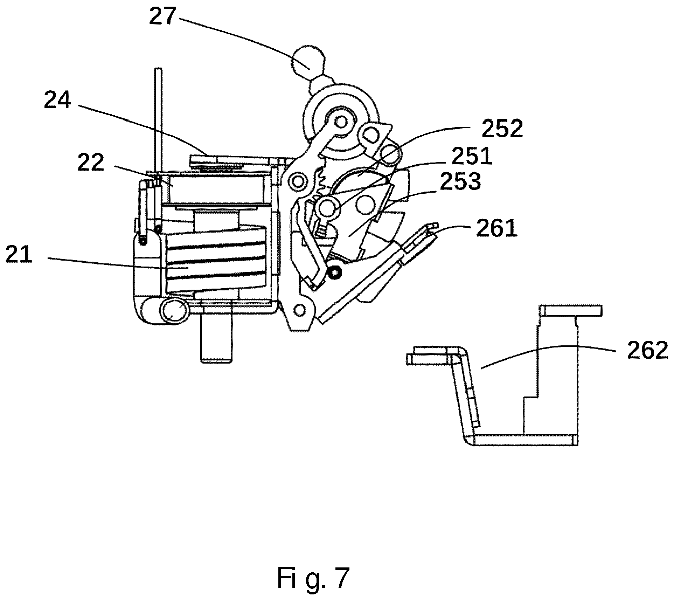

Next, referring to Figures 6 and 7, a detailed description is provided of the illustrative state diagrams for the circuit breaker module 20 of the leakage protection device 100 according to some embodiments of this application, in both normal operating mode and abnormal operating mode. The abnormal operating mode can include leakage faults, short circuit faults, and overload faults.

Figure 6 illustrates a schematic state diagram of the circuit breaker module 20 in normal operating mode. As shown in Figure 6, in normal operating mode, neither the first coil mechanism 21 nor the second coil mechanism 22 triggers the movement of the armature 24 (in this exemplary case, the armature 24 is arranged disengaged from the coil mechanism). The transmission mechanism 25 may include a lock latch 251, a jump latch 252, and a movable contact bracket 253. The lock latch 251 is releasably/unlockably connected to the jump latch 252, and the jump latch 252 is rotatably connected to the movable contact bracket 253, and the movable contact bracket 253 is rotatably connected to the movable contact 261. In normal operating mode, the lock latch 251 of the transmission mechanism 25 can engage with the jump latch 252 to lock each other, and the jump latch 252 can lock with the movable contact bracket 253, such that the transmission mechanism 25 substantially forms a four-bar linkage. This configuration allows the movable contact 261 to engage with the stationary contact 262, thereby closing or maintaining the conduction of the main circuit.

Figure 7 depicts a schematic state diagram of the circuit breaker module 20 in abnormal operating mode. As illustrated in Figure 7, the first coil mechanism 21 can be configured to trigger the movement of the armature 24 in the event of a short circuit fault in the main circuit, thus driving the movement of the contact assembly 26 via the transmission mechanism 25 to disconnect the main circuit. The second coil mechanism 22 is configured to trigger the movement of the armature 24 in the event of a leakage fault, thus driving the movement of the contact assembly 26 through the transmission mechanism 25 to disconnect the main circuit. In the case of a short circuit fault or a leakage fault, under the electromagnetic influence of the first or second coil, the armature 24 can cause the lock latch 251 to release from the jump latch 252, transforming the transmission mechanism 25 into a substantially five-bar linkage. This allows the movable contact bracket 253 to drive the movable contact 261 to disengage from the stationary contact 262, thereby disconnecting or maintaining the disconnection of the main circuit.

Furthermore, the handle 27 of the circuit breaker module 20 can be rotatably connected to the jump latch 252, thus allowing for manual control of the closing and disconnection of the movable contact 261 and stationary contact 262 via the handle 27.

Additionally, the overload detection device 28, such as a bimetallic strip means, directly drives the movement of the lock latch 251 (for instance, pushing the lock latch 251) upon detecting an overload fault, thereby unlocking the lock latch 251 from the jump latch 252. This action facilitates the disconnection of the movable contact bracket 253 from the movable contact 261 and stationary contact 262, disconnecting or maintaining the disconnection of the main circuit.

Although embodiments of the present invention have been shown and described, it will be appreciated by those of ordinary skill in the art that a variety of changes, modifications, substitutions and variations may be made to these embodiments without departing from the principles and spirit of the present invention, the scope of which is limited by the appended claims and their equivalents.

## Claims

1. A leakage protection device, wherein the leakage protection device comprises a leakage detection module and a circuit breaker module,
**characterized in that** the circuit breaker module comprises a first coil mechanism for short circuit protection and a second coil mechanism for leakage protection, wherein the leakage detection module is connected to the second coil mechanism via a first electrical transmission line, wherein the leakage protection device includes an intermediate housing arranged between the circuit breaker module and the leakage detection module, wherein the leakage detection module and the circuit breaker module are separated from each other by the intermediate housing, wherein the intermediate housing is provided with a through hole, wherein the first electrical transmission line extends from the leakage detection module through the through hole into the circuit breaker module, wherein no tripping mechanical transmission mechanism is present between the circuit breaker module and the leakage detection module, and no coil mechanism for leakage protection is provided within the leakage detection module.

2. The leakage protection device according to claim 1, **characterized in that** the first coil mechanism and the second coil mechanism are arranged coaxially.

3. The leakage protection device according to claim 2, **characterized in that** the first coil mechanism and the second coil mechanism are coaxially disposed on a core.

4. The leakage protection device according to claim 3, **characterized in that**:
the first coil mechanism comprises a first coil sleeve and a first coil wound around the first coil sleeve,
the second coil mechanism comprises a second coil sleeve and a second coil wound around the second coil sleeve,
wherein the first coil sleeve and the second coil sleeve are coaxially disposed on a core.

5. The leakage protection device according to claim 3, **characterized in that**:
the first coil mechanism and the second coil mechanism comprise a coil sleeve and a first coil and a second coil wound around the coil sleeve; or
the first coil mechanism comprises a first coil wound around a core, and the second coil mechanism comprises a second coil wound around the core; or
the first coil mechanism comprises a first coil wound around a core, and the second coil mechanism comprises a coil sleeve and a second coil wound around the coil sleeve.

6. The leakage protection device according to any one of claims 1 to 5, **characterized in that** the leakage detection module comprises a leakage detector and a circuit board, wherein the circuit board is connected to the second coil mechanism via a first electrical transmission line, and the leakage detector is connected to the circuit board via a second electrical transmission line.

7. The leakage protection device according to claim 6, **characterized in that** the leakage detection module further includes a simulated leakage operation part, which is configured to establish a leakage loop when the simulated leakage operation part is operated, thus simulating the occurrence of a leakage fault, wherein the leakage loop extends through the leakage detector, the simulated leakage operation part, and the circuit board.

8. The leakage protection device according to claim 6, **characterized in that** the leakage detection module further includes a communication module, which is configured to receive remote control signals, and the circuit board controls the second coil mechanism via the first electrical transmission line in response to the control signals.

9. The leakage protection device according to any one of claims 1 to 5, **characterized in that** the circuit breaker module further comprises:
an armature;
a transmission mechanism; and
a contact assembly, which includes a movable contact and a stationary contact,
wherein the armature, the transmission mechanism, and the contact assembly are mechanically connected to each other.

10. The leakage protection device according to claim 9, **characterized in that**
the first coil mechanism is configured to trigger the movement of the armature in the event of a short circuit fault occurring in the main circuit, thereby driving the movement of the contact assembly via the transmission mechanism for the purpose of disconnecting the main circuit, and
the second coil mechanism is configured to trigger the movement of the armature in the event of a leakage fault occurring, thereby driving the movement of the contact assembly via the transmission mechanism for the purpose of disconnecting the main circuit.

11. The leakage protection device according to claim 9, **characterized in that** the transmission mechanism comprises:
a lock latch;
a jump latch; and
a movable contact bracket,
wherein the lock latch and the jump latch are releasably connected to each other, the jump latch and the movable contact bracket are rotatably connected to each other, and the movable contact bracket and the movable contact are rotatably connected to each other.

12. The leakage protection device according to claim 11, **characterized in that**:
in a normal operating mode, the lock latch and the jump latch match and lock with each other, and the jump latch and the movable contact bracket match and lock with each other, such that the transmission mechanism forms a four-bar linkage, thereby making the movable contact engage with the stationary contact;
in the event of a short circuit fault or a leakage fault, the armature drives the lock latch and the jump latch to unlock, such that the transmission mechanism transforms into a five-bar linkage, thereby enabling the movable contact bracket to drive the movable contact to disconnect from the stationary contact.

13. The leakage protection device according to claim 11, **characterized in that** the circuit breaker module further includes a handle, which is rotatably connected to the jump latch.

14. The leakage protection device according to claim 11, **characterized in that** the circuit breaker module further includes an overload detection device, which is configured to detect overload faults in the main circuit, and directly causes the movement of the lock latch to unlock the lock latch from the jump latch upon detecting an overload fault.

15. The leakage protection device according to claim 14, **characterized in that** the overload detection device is configured as a bimetallic strip means, and deforms due to heating when an overload fault occurs in the main circuit, thereby pushing the lock latch.

16. The leakage protection device according to any one of claims 1 to 5, **characterized in that** the circuit breaker module comprises an emergency switch and an emergency switch transmission line, wherein the emergency switch is electrically connected to the second coil mechanism via the emergency switch transmission line; and/or the circuit breaker module includes a remote control transmission line, which is electrically connected to the second coil mechanism.

17. An electrical device, **characterized in that** the electrical device comprises a first power supply line from a power source, a second power supply line leading to a load, and the leakage protection device according to any one of claims 1 to 16, wherein the first power supply line is connected to the input terminal of the leakage protection device and the second power supply line is connected to the output terminal of the leakage protection device.
